# EUROPEAN PATENT APPLICATION

(11) **EP 4 156 157 A1**
(43) Date of publication of application: **29.03.2023**
(21) Application number: 21809494.4
(22) Date of filing: 28.04.2021
(51) Int. Cl.: G09F 9/33, H01L 33/50

(54) **LIGHT-EMITTING MODULE, DISPLAY MODULE, DISPLAY SCREEN, AND DISPLAY**

(30) Priority: 22.05.2020 CN 202010439790
(71) Applicant: Beijing Ivisual 3D Technology Co., Ltd., Beijing 100055 (CN); Visiotech Ventures Pte. Ltd., Singapore 188979 (SG)
(72) Inventor: DIAO, Honghao, Beijing 100055 (CN)
(74) Representative: Zacco GmbH
(86) International application number: PCT/CN2021/090613
(87) International publication number: WO 2021/233100

(57) **Abstract**

The present application relates to the technical field of optics, and discloses a light-emitting module (100), including: a light conversion layer (410), including a plurality of pixel units (411), where a pixel light isolation structure (500) is arranged between two adjacent pixel units (411) in part or all of the plurality of pixel units (411). According to the light-emitting module (100), light emitted by the light conversion layer (410) is prevented from being transmitted in an undesired direction as far as possible by arranging the pixel light isolation structure (500) between two adjacent pixel units (411) in part or all of the plurality of pixel units (411) in the light conversion layer (410), thereby benefiting improvement of a display effect. The present application further discloses a display module (700), a display screen (800) and a display (900).

## Description

The present application claims priority to the Chinese Patent Application with an application number of 202010439790.9 and a title of *"Light-emitting Module, Display Module, Display Screen and Display",* filed to China National Intellectual Property Administration on May, 22nd, 2020, the disclosures of which are hereby incorporated by reference.

### TECHNICAL FIELD

The present application relates to the technical field of optics, and for example, relates to a light-emitting module, a display module, a display screen and a display.

### BACKGROUND

At present, a light conversion layer is usually used to support display.

In a process of implementing embodiments of the present disclosure, at least the following problems are found in related technologies:
Part of light emitted by the light conversion layer will be transmitted in an undesired direction; and the light transmitted in the undesired direction will influence a display effect.

### SUMMARY

In order to provide a basic understanding of some aspects of the disclosed embodiments, a brief summary is given below. The summary is not intended to be a general comment, nor to identify key/important components or describe the scope of protection of the embodiments, but to be a preface to the following detailed description.

Embodiments of the present disclosure provide a light-emitting module, a display module, a display screen and a display, to solve a technical problem that part of light emitted by a light conversion layer will be transmitted in an undesired direction and a display effect is influenced.

The light-emitting module provided by embodiments of the present disclosure includes:
a light conversion layer, including a plurality of pixel units,
where a pixel light isolation structure is arranged between two adjacent pixel units in part or all of the plurality of pixel units.

In some embodiments, the pixel light isolation structure may be arranged in a partial or whole region between the two adjacent pixel units.

In some embodiments, there may be a pixel spacing region between two adjacent pixel units; and the pixel light isolation structure may be arranged in part or whole of the pixel spacing region.

In some embodiments, the two adjacent pixel units may include a first pixel unit and a second pixel unit, where the first pixel unit may include a first surface close to the second pixel unit; and the second pixel unit may include a second surface close to the first pixel unit. Optionally, the pixel light isolation structure may be arranged on at least one of the first surface and the second surface, or is not in contact with the first surface or the second surface.

In some embodiments, the pixel light isolation structure may be arranged in a light-transmissive region of at least one of the first surface and the second surface.

In some embodiments, the pixel light isolation structure may be a single integral closed structure.

In some embodiments, the pixel light isolation structure may include a pixel light isolation body.

In some embodiments, the pixel light isolation body may include a light isolation material.

In some embodiments, the pixel light isolation structure may further include a spacing structure arranged between the pixel light isolation body and a pixel unit in need of light isolation.

In some embodiments, the spacing structure may be arranged between the pixel light isolation body and at least one of two adjacent pixel units.

In some embodiments, the spacing structure may cover a part or whole of the pixel light isolation body.

In some embodiments, at least one of the pixel light isolation body and the spacing structure may include the light isolation material.

In some embodiments, the light isolation material may include at least one of a light absorption material and a light reflection material.

In some embodiments, part or all shapes in cross-sectional shapes of the pixel light isolation structure along a light-incoming direction of the light conversion layer may include at least one of a rectangular quadrangle, a triangle and a trapezoid.

In some embodiments, the cross-sectional shapes of the pixel light isolation structure along the light-incoming direction of the light conversion layer may include a trapezoid; and a lower base of the trapezoid may face a light-incoming side of the light conversion layer.

In some embodiments, the plurality of pixel units may include:
at least one of pixels and subpixels.

In some embodiments, at least two pixel units of the plurality of pixel units may include same or different light conversion materials.

In some embodiments, the light-emitting module may further include a light-emitting unit layer. Optionally, the light conversion layer may be arranged at the light-emitting unit layer.

In some embodiments, the pixel light isolation structure may be in direct contact with the light-emitting unit layer.

In some embodiments, the light conversion layer may be arranged at a light-exiting surface of the light-emitting unit layer.

In some embodiments, the light-emitting unit layer may include a plurality of light-emitting units.

In some embodiments, part or all of the plurality of light-emitting units may be unpackaged structures.

In some embodiments, the plurality of light-emitting units may include:
at least one of a Light-Emitting Diode (LED), a Mini LED and a Micro LED.

The display module provided by embodiments of the present disclosure includes the light-emitting module.

The display screen provided by embodiments of the present disclosure includes the display module.

The display provided by embodiments of the present disclosure includes the display screen.

The light-emitting module, the display module, the display screen and the display provided by embodiments of the present disclosure may achieve the following technical effects:
Light emitted by the light conversion layer is prevented from being transmitted in an undesired direction as far as possible by arranging the pixel light isolation structure between two adjacent pixel units in part or all of the plurality of pixel units in the light conversion layer, thereby benefiting improvement of a display effect.

The above general description and the following description are exemplary and explanatory only, and are not intended to limit the present application.

### DESCRIPTION OF DRAWINGS

One or more embodiments are illustrated by the corresponding drawings, and the illustrations and drawings do not limit the embodiments. Elements having the same reference numerals in the drawings are shown as similar elements, and the drawings are not intended to limit the scale, where:
Fig. 1 is a structural schematic diagram of a light-emitting module provided by embodiments of the present disclosure;
Figs. 2A, 2B and 2C are structural schematic diagrams of a pixel light isolation structure provided by embodiments of the present disclosure;
Figs. 3A, 3B, 3C, 3D and 3E are other structural schematic diagrams of the pixel light isolation structure provided by embodiments of the present disclosure;
Figs. 4A, 4B, 4C and 4D are other structural schematic diagrams of the pixel light isolation structure provided by embodiments of the present disclosure;
Figs. 5A, 5B, 5C, 5D, 5E, 5F, 5G, 5H, 51, 5J, 5K, 5L, 5M and 5N are other structural schematic diagrams of the pixel light isolation structure provided by embodiments of the present disclosure;
Fig. 6 is a structural schematic diagram of a pixel light isolation body provided by embodiments of the present disclosure;
Fig. 7 is another structural schematic diagram of the pixel light isolation body provided by embodiments of the present disclosure;
Fig. 8 is another structural schematic diagram of the pixel light isolation structure provided by embodiments of the present disclosure;
Figs. 9A, 9B and 9C are other structural schematic diagrams of the pixel light isolation structure provided by embodiments of the present disclosure;
Figs. 10A, 10B, 10C, 10D and 10E are other structural schematic diagrams of the pixel light isolation structure provided by embodiments of the present disclosure;
Figs. 11A, 11B, 11C, 11D and 11E are other structural schematic diagrams of the pixel light isolation structure provided by embodiments of the present disclosure;
Figs. 12A, 12B, 12C and 12D are other structural schematic diagrams of a light isolation material provided by embodiments of the present disclosure;
Figs. 13A, 13B, 13C, 13D, 13E, 13F, 13G and 13H are other structural schematic diagrams of the light-emitting module provided by embodiments of the present disclosure;
Fig. 14 is another schematic diagram of the light-emitting module provided by embodiments of the present disclosure;
Fig. 15 is another schematic diagram of the light-emitting module provided by embodiments of the present disclosure;
Fig. 16 is a structural schematic diagram of a light-emitting unit layer provided by embodiments of the present disclosure;
Fig. 17 is a structural schematic diagram of a display module provided by embodiments of the present disclosure;
Fig. 18 is a structural schematic diagram of a display screen provided by embodiments of the present disclosure; and
Fig. 19 is a structural schematic diagram of a display provided by embodiments of the present disclosure.

Reference numerals:
100: light-emitting module; 110: light-emitting unit layer; 111: light-emitting unit; 410: light conversion layer; 411: pixel unit; 500: pixel light isolation structure; 501: pixel light isolation body; 502: light isolation material; 5021: light absorption material; 5022: light reflection material; 503: spacing structure; 510: pixel spacing region; 520: first pixel unit; 521: first surface; 530: second pixel unit; 531: second surface; 533: light-transmissive region; 534: light-transmissive region; D: lower base; E: light-incoming side; P: plane direction; S: light-exiting surface; Y: light-incoming direction; 700: display module; 800: display screen; and 900: display.

### DETAILED DESCRIPTION

To understand features and technical contents of embodiments of the present disclosure in more detail, implementation of the embodiments of the present disclosure is described in detail below with reference to accompanying drawings; and the accompanying drawings are used for reference only, rather than limiting the embodiments of the present disclosure. In following technical description, for the convenience of explanation, a thorough understanding of the disclosed embodiments is provided through more details. However, one or more embodiments may be implemented without the details. In other cases, to simplify the accompanying drawings, well-known structures and apparatuses may be shown simplistically.

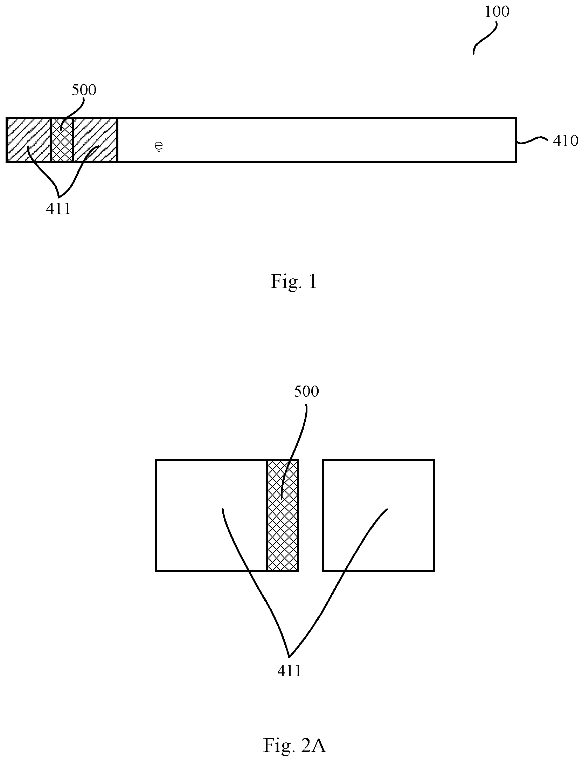

Referring to Fig. 1, embodiments of the present disclosure provide a light-emitting module 100, including:
a light conversion layer 410, including a plurality of pixel units 411,
where a pixel light isolation structure 500 is arranged between two adjacent pixel units 411 in part or all of the plurality of pixel units 411.

In this way, the pixel light isolation structure 500 is capable of preventing light emitted by two adjacent pixel units 411 from being transmitted in an undesired direction as far as possible (e.g., the light emitted by the two adjacent pixel units 411 is transmitted to each other), thereby benefiting improvement of display effect.

In some embodiments, the light conversion layer 410 may realize color conversion of light in a way of wavelength selection, for example, at least one of the plurality of pixel units 411 included in the light conversion layer 410 performs color conversion on light from the light-emitting unit layer.

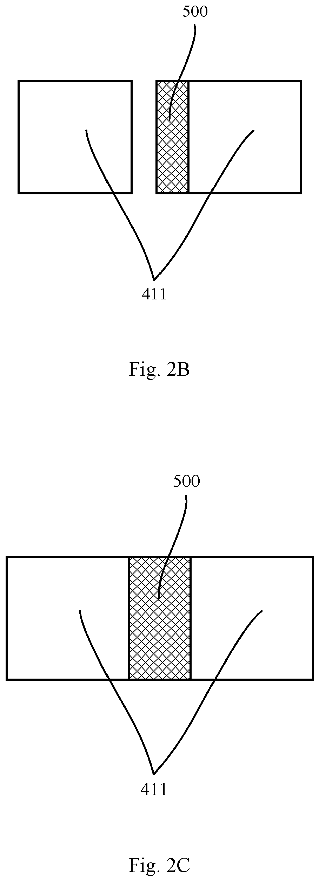

Referring to Figs. 2A, 2B and 2C, in some embodiments, the pixel light isolation structure 500 may be arranged in a partial or whole region between the two adjacent pixel units 411.

In some embodiments, as shown in Fig. 2A, the pixel light isolation structure 500 is arranged in the partial region between the two adjacent pixel units 411; and the partial region is located between the two adjacent pixel units 411 and close to one of the pixel units 411 (a pixel unit 411 located on the left in the figure).

In some embodiments, as shown in Fig. 2B, the pixel light isolation structure 500 is arranged in a partial region between the two adjacent pixel units 411; and the partial region is located between the two adjacent pixel units 411 and opposite to a position of the pixel light isolation structure 500 in Fig. 2A (close to a pixel unit 411 located on the right in the figure).

In some embodiments, as shown in Fig. 2C, the pixel light isolation structure 500 is arranged in a whole region between the two adjacent pixel units 411.

In some embodiments, a region, where the pixel light isolation structure 500 is arranged, between the two adjacent pixel units 411 may be determined according to actual conditions such as process requirements, as long as the pixel light isolation structure 500 is capable of preventing the light emitted by the two adjacent pixel units 411 from being transmitted in an undesired direction (e.g., the light emitted by the two adjacent pixel units 411 is transmitted to each other).

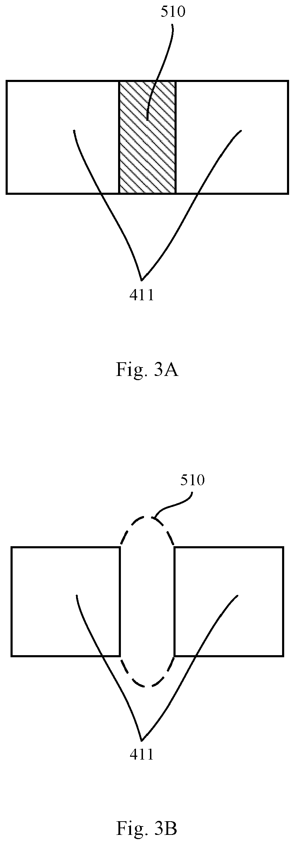

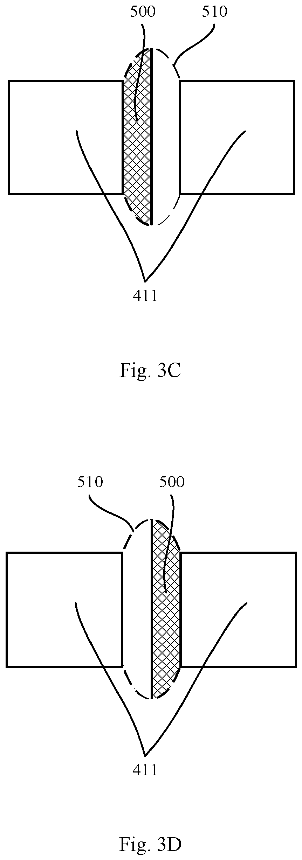

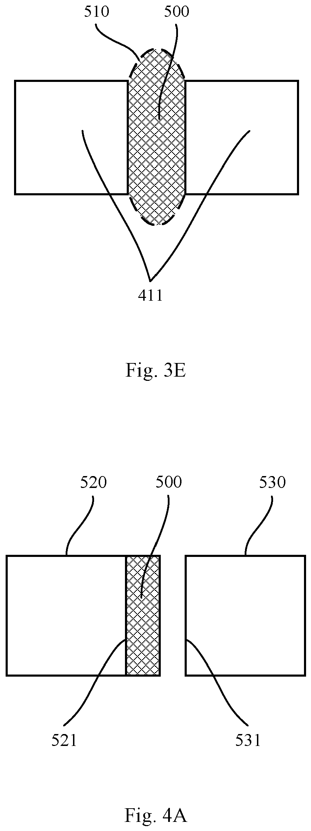

Referring to Figs. 3A, 3B, 3C, 3D and 3E, in some embodiments, there may be a pixel spacing region 510 between two adjacent pixel units 411; and the pixel light isolation structure 500 may be arranged in a part or whole of the pixel spacing region 510.

In some embodiments, as shown in Fig. 3A, a pixel spacing region 510 having a rectangular quadrangle shape may be used as the pixel spacing region between the two adjacent pixel units 411; the pixel spacing region 510 may smoothly connect the two adjacent pixel units 411, so that a projection jointly formed by the two adjacent pixel units 411 and the pixel spacing region 510 may form a regular shape such as a rectangular quadrangle as shown in Fig. 3A.

In some embodiments, the pixel spacing region 510 between the two adjacent pixel units 411 may not have the shape of the pixel spacing region 510 as shown in Fig. 3A, but may have other shapes such as circle, ellipse, triangle and trapezoid. Optionally, when the pixel spacing region 510 between the two adjacent pixel units 411 has other shapes such as circle, ellipse, triangle and trapezoid, the pixel spacing region 510 is possible to smoothly connect the two adjacent pixel units 411, so that the projection jointly formed by the two adjacent pixel units 411 and the pixel spacing region 510 may form a regular shape such as the rectangular quadrangle as shown in Fig. 3A.

In some embodiments, the position, shape, size and the like of the pixel spacing region 510 between the two adjacent pixel units 411 may be determined according to actual conditions such as process requirements. Optionally, regardless of the shape of the pixel spacing region 510 between the two adjacent pixel units 411, for convenience of description, a pixel spacing region 510 having an approximate ellipse shape shown by a dotted line in Fig. 3B may also be used as the pixel spacing region between the two adjacent pixel units 411.

In some embodiments, as shown in Fig. 3C, the pixel light isolation structure 500 is arranged in a partial region of the pixel spacing region 510 between the two adjacent pixel units 411; and the partial region is located between the two adjacent pixel units 411 and close to one of the pixel units 411 (a pixel unit 411 located on the left in the figure).

In some embodiments, as shown in Fig. 3D, the pixel light isolation structure 500 is arranged in a partial region of the pixel spacing region 510 between the two adjacent pixel units 411; and the partial region is located between the two adjacent pixel units 411 and opposite to a position of the pixel light isolation structure 500 in Fig. 3C (close to a pixel unit 411 located on the right in the figure).

In some embodiments, as shown in Fig. 3E, the pixel light isolation structure 500 is arranged in a whole region of the pixel spacing region 510 between the two adjacent pixel units 411.

In some embodiments, a position, where the pixel light isolation structure 500 is arranged, in the pixel spacing region 510 between the two adjacent pixel units 411 may be determined according to actual conditions such as process requirements, as long as the pixel light isolation structure 500 is capable of preventing the light emitted by the two adjacent pixel units 411 from being transmitted in an undesired direction (e.g., the light emitted by the two adjacent pixel units 411 is transmitted to each other).

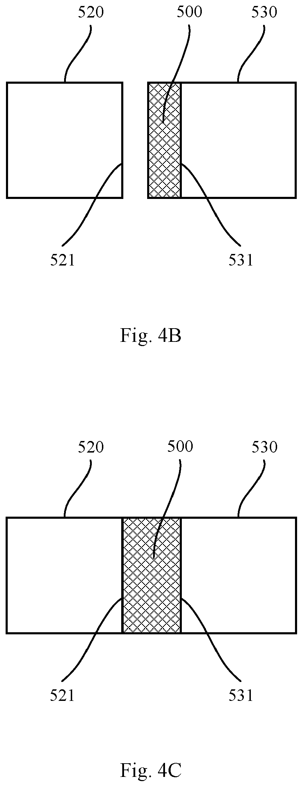

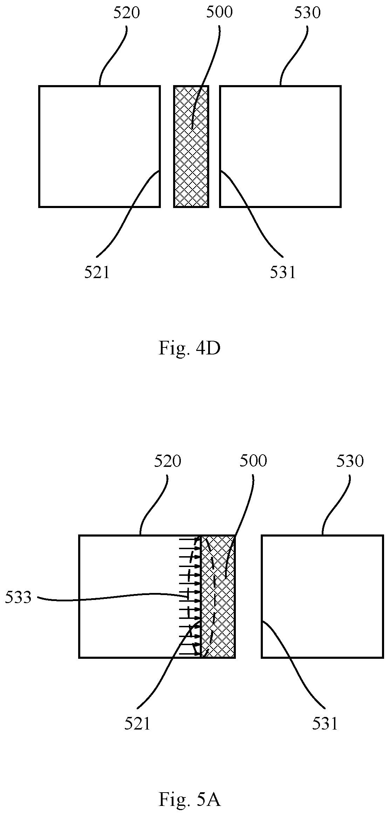

Referring to Figs. 4A, 4B, 4C and 4D, in some embodiments, the two adjacent pixel units 411 may include a first pixel unit 520 and a second pixel unit 530; the first pixel unit 520 may include a first surface 521 close to the second pixel unit 530; and the second pixel unit 530 may include a second surface 531 close to the first pixel unit 520. Optionally, the pixel light isolation structure 500 may be arranged on at least one of the first surface 521 and the second surface 531 , or is not in contact with the first surface 521 or the second surface 531.

In some embodiments, as shown in Fig. 4A, the pixel light isolation structure 500 is arranged at the first surface 521 of the first pixel unit 520, in contact with the first surface 521 of the first pixel unit 520, but not in contact with the second surface 531 of the second pixel unit 530.

In some embodiments, as shown in Fig. 4B, the pixel light isolation structure 500 is arranged at the second surface 531 of the second pixel unit 530, in contact with the second surface 531 of the second pixel unit 530, but not in contact with the first surface 521 of the first pixel unit 520.

In some embodiments, as shown in Fig. 4C, the pixel light isolation structure 500 is arranged at the first surface 521 of the first pixel unit 520 and the second surface 531 of the second pixel unit 530, in contact with the first surface 521 of the first pixel unit 520, and in contact with the second surface 531 of the second pixel unit 530.

In some embodiments, as shown in Fig. 4D, the pixel light isolation structure 500 is arranged at the first surface 521 of the first pixel unit 520 and the second surface 531 of the second pixel unit 530, not in contact with the first surface 521 of the first pixel unit 520, and not in contact with the second surface 531 of the second pixel unit 530.

In some embodiments, an arrangement relationship between the pixel light isolation structure 500 and each of the first pixel unit 520 and the second pixel unit 530 may be determined according to actual conditions such as process requirements, as long as the pixel light isolation structure 500 is capable of preventing the light emitted by the first pixel unit 520 and the second pixel unit 530 from being transmitted in an undesired direction (e.g., the light emitted by the first pixel unit 520 and the second pixel unit 530 is transmitted to each other).

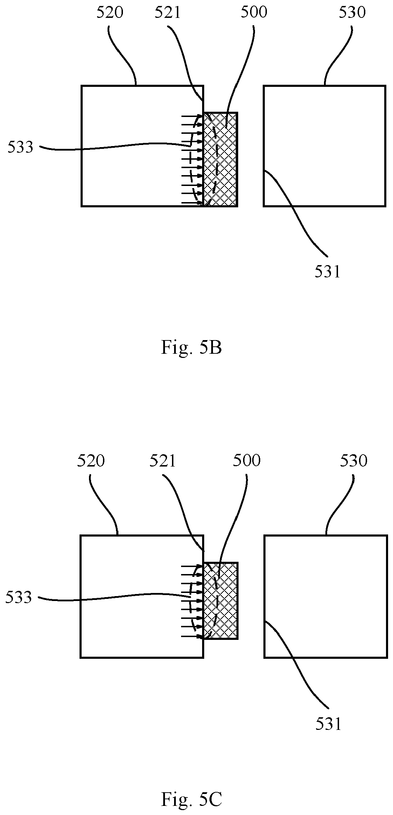

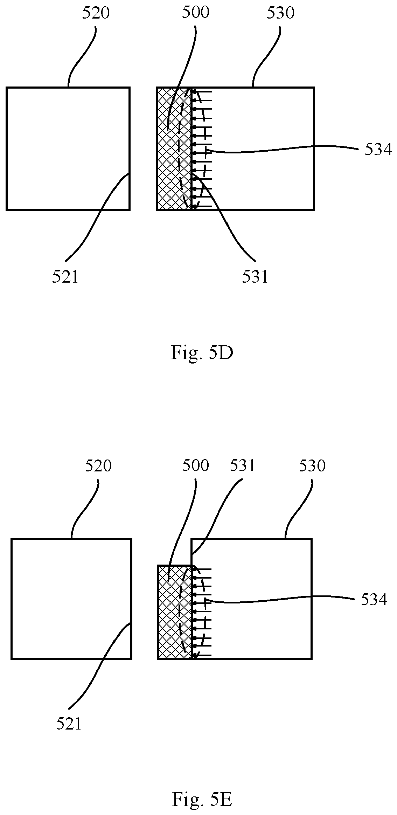

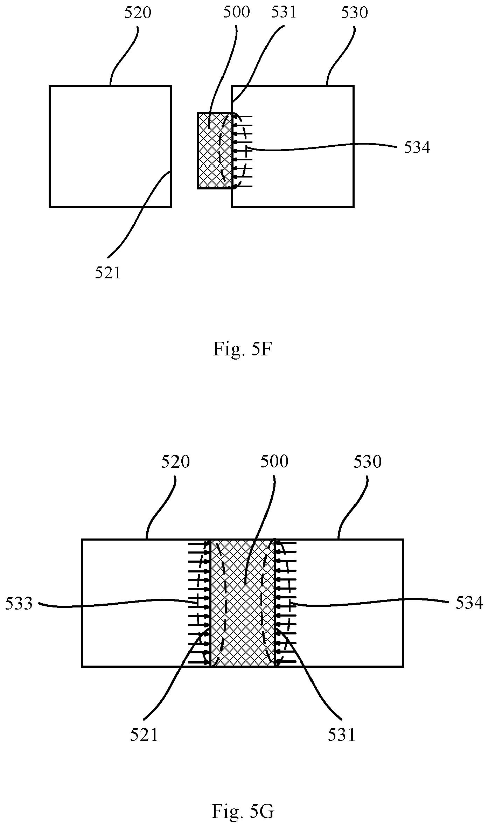

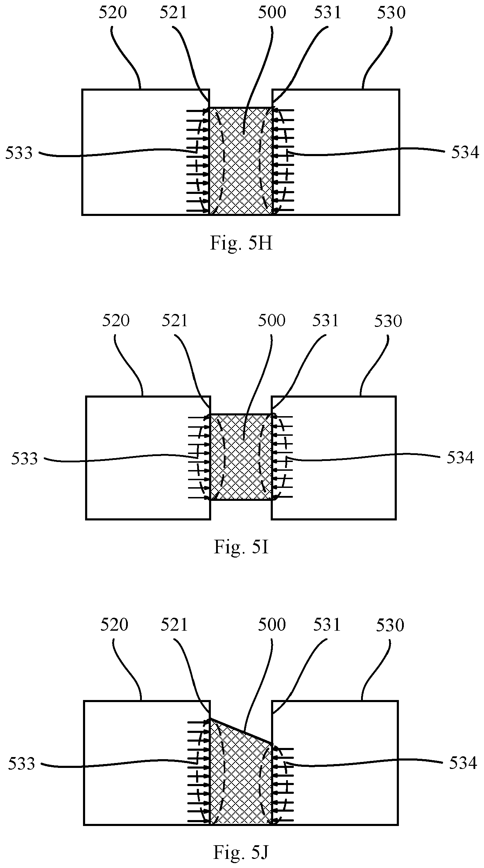

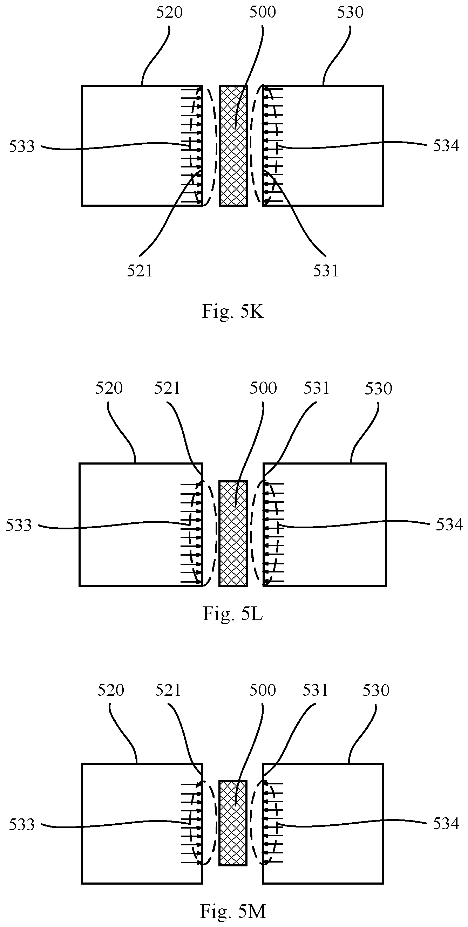

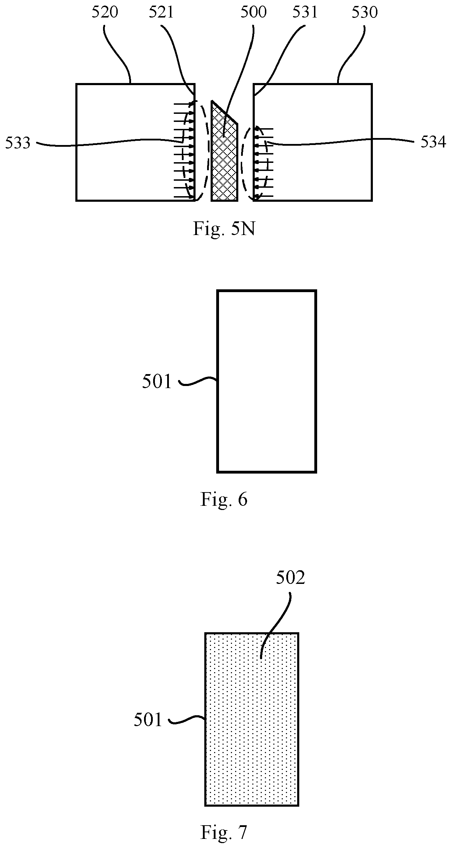

Referring to Figs. 5A, 5B, 5C, 5D, 5E, 5F, 5G, 5H, 51, 5J, 5K, 5L, 5M and 5N, in some embodiments, the pixel light isolation structure 500 may be arranged in a light-transmissive region 534 of at least one of the first surface 521 and the second surface 531.

In some embodiments, as shown in Figs. 5A, 5B, 5C, 5D, 5E, 5F, 5G, 5H, 51, 5J, 5K, 5L, 5M and 5N, the arrow graphics exemplarily show a direction of a part of light emitted by the pixel units 411. Optionally, for the convenience of identification, the light-transmissive regions 533 and 534 are surrounded by dotted lines.

In some embodiments, as shown in Fig. 5A, the light-transmissive region 533 of the first surface 521 of the first pixel unit 520 includes a whole region of the first surface 521. In this case, the pixel light isolation structure 500 may be arranged in the whole region of the first surface 521 and in contact with the whole region of the first surface 521, so that the pixel light isolation structure 500 may be arranged in the light-transmissive region 533 of the first surface 521.

In some embodiments, as shown in Figs. 5B and 5C, the light-transmissive region 533 of the first surface 521 of the first pixel unit 520 includes a partial region of the first surface 521. In this case, the pixel light isolation structure 500 may be arranged in a corresponding partial region of the first surface 521 and in contact with the corresponding partial region of the first surface 521, so that the pixel light isolation structure 500 may be arranged in the light-transmissive region 533 of the first surface 521.

In some embodiments, as shown in Fig. 5D, the light-transmissive region 534 of the second surface 531 of the second pixel unit 530 includes a whole region of the second surface 531. In this case, the pixel light isolation structure 500 may be arranged in the whole region of the second surface 531 and in contact with the whole region of the second surface 531, so that the pixel light isolation structure 500 may be arranged in the light-transmissive region 534 of the second surface 531.

In some embodiments, as shown in Figs. 5E and 5F, the light-transmissive region 534 of the second surface 531 of the second pixel unit 530 includes a partial region of the second surface 531. In this case, the pixel light isolation structure 500 may be arranged in a corresponding partial region of the second surface 531 and in contact with the corresponding partial region of the second surface 531, so that the pixel light isolation structure 500 may be arranged in the light-transmissive region 534 of the second surface 531.

In some embodiments, as shown in Fig. 5G, the light-transmissive region 533 of the first surface 521 of the first pixel unit 520 includes a whole region of the first surface 521; and the light-transmissive region 534 of the second surface 531 of the second pixel unit 530 includes a whole region of the second surface 531. In this case, the pixel light isolation structure 500 may be arranged in the whole region of the first surface 521 and the whole region of the second surface 531, and in contact with the whole region of the first surface 521 and the whole region of the second surface 531, so that the pixel light isolation structure 500 may be arranged in the light-transmissive region 533 of the first surface 521 and the light-transmissive region 534 of the second surface 531.

In some embodiments, as shown in Figs. 5H and 5I, the light-transmissive region 533 of the first surface 521 of the first pixel unit 520 includes a partial region of the first surface 521; the light-transmissive region 534 of the second surface 531 of the second pixel unit 530 includes a partial region of the second surface 531; and the light-transmissive region 533 of the first surface 521 is consistent with the light-transmissive region 534 of the second surface 531 (e.g., identical in at least one of position, shape, area and the like). In this case, the pixel light isolation structure 500 may be arranged in corresponding partial regions of the first surface 521 and the second surface 531, and in contact with the corresponding partial regions of the first surface 521 and the second surface 531, so that the pixel light isolation structure 500 may be arranged at the first surface 521 and the light-transmissive region 534 of the second surface 531.

In some embodiments, as shown in Fig. 5J, the light-transmissive region 533 of the first surface 521 of the first pixel unit 520 includes a partial region of the first surface 521; the light-transmissive region 534 of the second surface 531 of the second pixel unit 530 includes a partial region of the second surface 531; and the light-transmissive region 533 of the first surface 521 is inconsistent with the light-transmissive region 534 of the second surface 531 (e.g., being different in at least one of position, shape, area and the like). In this case, the pixel light isolation structure 500 may be arranged in corresponding partial regions of the first surface 521 and the second surface 531, and in contact with the corresponding partial regions of the first surface 521 and the second surface 531, so that the pixel light isolation structure 500 may be arranged at the first surface 521 and the light-transmissive region 534 of the second surface 531.

In some embodiments, the light-transmissive region 533 of the first surface 521 of the first pixel unit 520 may include a whole region of the first surface 521; and the light-transmissive region 534 of the second surface 531 of the second pixel unit 530 may include a partial region of the second surface 531. In this case, the pixel light isolation structure 500 may be arranged in the whole region of the first surface 521 and the partial region of the second surface 531, and in contact with the whole region of the first surface 521 and the partial region of the second surface 531, so that the pixel light isolation structure 500 may be arranged at the first surface 521 and the light-transmissive region 534 of the second surface 531. Optionally, the light-transmissive region 533 of the first surface 521 of the first pixel unit 520 may include a partial region of the first surface 521; and the light-transmissive region 534 of the second surface 531 of the second pixel unit 530 may include a whole region of the second surface 531. In this case, the pixel light isolation structure 500 may be arranged in the partial region of the first surface 521 and the whole region of the second surface 531, and in contact with the partial region of the first surface 521 and the whole region of the second surface 531, so that the pixel light isolation structure 500 may be arranged at the first surface 521 and the light-transmissive region 534 of the second surface 531.

In some embodiments, as shown in Fig. 5K, the light-transmissive region 533 of the first surface 521 of the first pixel unit 520 includes a whole region of the first surface 521 and a whole region of the second surface 531. In this case, the pixel light isolation structure 500 may be arranged between the whole region of the first surface 521 and the whole region of the second surface 531, and not be in contact with the first surface 521 or the second surface 531, so that the pixel light isolation structure 500 may be arranged between the light-transmissive region 533 of the first surface 521 and the light-transmissive region 534 of the second surface 531.

In some embodiments, as shown in Figs. 5L and 5M, the light-transmissive region 533 of the first surface 521 of the first pixel unit 520 includes a partial region of the first surface 521; the light-transmissive region 534 of the second surface 531 of the second pixel unit 530 includes a partial region of the second surface 531; and the light-transmissive region 533 of the first surface 521 is consistent with the light-transmissive region 534 of the second surface 531 (e.g., identical in at least one of position, shape, area and the like). In this case, the pixel light isolation structure 500 may be arranged between corresponding partial regions of the first surface 521 and the second surface 531, and not be in contact with the first surface 521 or the second surface 531, so that the pixel light isolation structure 500 may be arranged between the light-transmissive region 533 of the first surface 521 and the light-transmissive region 534 of the second surface 531.

In some embodiments, as shown in Fig. 5N, the light-transmissive region 533 of the first surface 521 of the first pixel unit 520 includes a partial region of the first surface 521; the light-transmissive region 534 of the second surface 531 of the second pixel unit 530 includes a partial region of the second surface 531; and the light-transmissive region 533 of the first surface 521 is inconsistent with the light-transmissive region 534 of the second surface 531 (e.g., different in at least one of position, shape, area and the like). In this case, the pixel light isolation structure 500 may be arranged between a corresponding partial region of the first surface 521 and a corresponding partial region of the second surface 531, and not be in contact with the first surface 521 or the second surface 531, so that the pixel light isolation structure 500 may be arranged between the first surface 521 and the light-transmissive region 534 of the second surface 531.

In some embodiments, the light-transmissive region 533 of the first surface 521 of the first pixel unit 520 may include a whole region of the first surface 521; and the light-transmissive region 534 of the second surface 531 of the second pixel unit 530 may include a partial region of the second surface 531. In this case, the pixel light isolation structure 500 may be arranged between the whole region of the first surface 521 and the partial region of the second surface 531, and not be in contact with the first surface 521 or the second surface 531, so that the pixel light isolation structure 500 may be arranged between the first surface 521 and the light-transmissive region 534 of the second surface 531. Optionally, the light-transmissive region 533 of the first surface 521 of the first pixel unit 520 may include a partial region of the first surface 521; and the light-transmissive region 534 of the second surface 531 of the second pixel unit 530 may include a whole region of the second surface 531. In this case, the pixel light isolation structure 500 may be arranged between the partial region of the first surface 521 and the whole region of the second surface 531, and not be in contact with the first surface 521 or the second surface 531, so that the pixel light isolation structure 500 may be arranged between the first surface 521 and the light-transmissive region 534 of the second surface 531.

In some embodiments, the pixel regions 533 and 534 of the pixel units 411 may be a continuous region. In this case, the pixel light isolation structure 500 may be arranged in the continuous region, and may or may not be in contact with the continuous region, so that the pixel light isolation structure 500 may be arranged in the light-transmissive regions 533 and 534 of the pixel units 411. In some embodiments, the light-transmissive regions 533 and 534 of the pixel units 411 may be a discontinuous region. In this case, the pixel light isolation structure 500 may be arranged in the discontinuous region, and may or may not be in contact with the discontinuous region, so that the pixel light isolation structure 500 may be arranged in the light-transmissive regions 533 and 534 of the pixel units 411. Optionally, the position, number and the like of the discontinuous regions for allowing arrangement of the pixel light isolation structure 500 may be determined according to actual light-transmissive conditions such as process requirements, so that the pixel light isolation structure 500 may be arranged in the light-transmissive regions 533 and 534 of the pixel units 411 presented as the discontinuous region.

In some embodiments, the light-transmissive regions 533 and 534 of the pixel units 411 may be determined according to actual light-transmissive conditions such as process requirements; and accordingly, it is considered that the pixel light isolation structure 500 is arranged between the light-transmissive regions 533 and 534 of the pixel units 411 or the corresponding light-transmissive regions 533 and 534 of two adjacent pixel units 411. Optionally, the light-transmissive regions 533 and 534 may include part or all of regions of the pixel units 411, and may be presented in a form of continuous regions or discontinuous regions; and the corresponding position, quantity and the like may be determined according to actual light-transmissive conditions such as process requirements, as long as the pixel light isolation structure 500 is capable of preventing the light emitted by the two adjacent pixel units 411 from being transmitted in an undesired direction (e.g., the light emitted by the first pixel unit 520 and the second pixel unit 530 is transmitted to each other).

In some embodiments, referring to corresponding exemplary structures in Figs. 1, 2A, 2B, 2C, 3C, 3D, 3E, 4A, 4B, 4C, 4D, 5A, 5B, 5C, 5D, 5E, 5F, 5G, 5H, 51, 5J, 5K, 5L, 5M and 5N, part or all of the pixel light isolation structures 500 may be a single integral closed structure; for example, part or all of the pixel light isolation structures 500 may be the single integral closed structure, in a longitudinal section of the light-emitting module 100. Optionally, part or all of the pixel light isolation structures 500 may be a complete single integral structure, excluding split structures formed in splicing or other modes. Optionally, surfaces (or referred to as outer profiles) of part or all of the pixel light isolation structures 500 may be closed and have no opening, so that the corresponding pixel light isolation structures 500 are formed as closed structures.

In some embodiments, part or all of the pixel light isolation structures 500, as the single integral closed structure, may be solid structures or hollow structures.

In some embodiments, part or all of the pixel light isolation structures 500 may be different from the complete single integral structure, but include the split structures formed in splicing or other modes. Optionally, surfaces (or referred to as outer profiles) of part or all of the pixel light isolation structures 500 may be unclosed and have openings, so that the pixel light isolation structures 500 are formed as unclosed structures (or referred to as open structures).

In some embodiments, part or all of the pixel light isolation structures 500 may be set to be single integral closed structures or unclosed structures according to actual conditions such as process requirements, or part or all of the pixel light isolation structures 500 may be set to be solid structures or hollow structures according to actual conditions such as process requirements, as long as the pixel light isolation structures 500 are capable of preventing the light emitted by two adjacent pixel units 411 from being transmitted in an undesired direction (e.g., the light emitted by the first pixel unit 520 and the second pixel unit 530 is transmitted to each other).

Referring to Fig. 6, in some embodiments, the pixel light isolation structure 500 may include a pixel light isolation body 501.

Referring to Fig. 7, in some embodiments, the pixel light isolation body 501 may include a light isolation material 502.

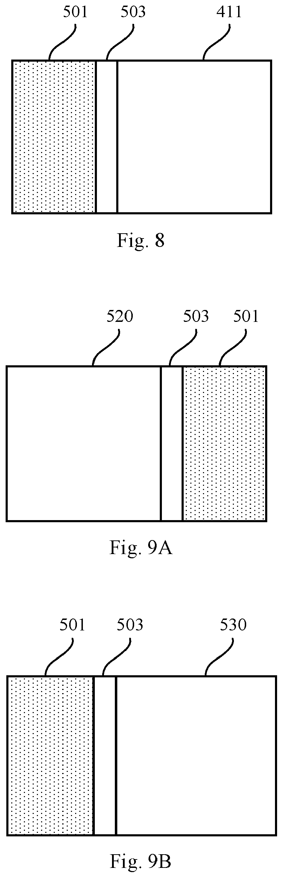

Referring to Fig. 8, in some embodiments, the pixel light isolation structure 500 may further include a spacing structure 503 arranged between the pixel light isolation body 501 and a pixel unit 411 in need of light isolation.

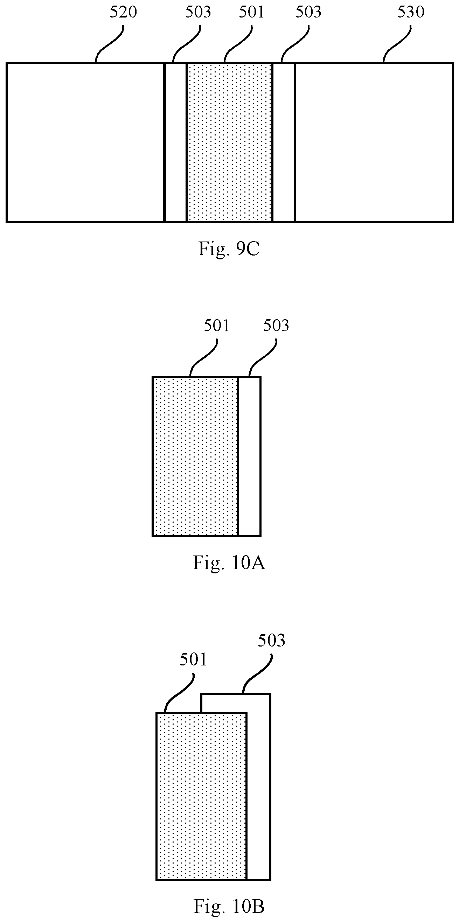

Referring to Figs. 9A, 9B and 9C, in some embodiments, the spacing structure 503 may be arranged between the pixel light isolation body 501 and at least one of the two adjacent pixel units 411.

In some embodiments, as shown in Fig. 9A, when the two adjacent pixel units 411 include the first pixel unit 520 and the second pixel unit 530, the spacing structure 503 is arranged between the pixel light isolation body 501 and the first pixel unit 520.

In some embodiments, as shown in Fig. 9B, when the two adjacent pixel units 411 include the first pixel unit 520 and the second pixel unit 530, the spacing structure 503 is arranged between the pixel light isolation body 501 and the second pixel unit 530.

In some embodiments, as shown in Fig. 9C, when the two adjacent pixel units 411 include the first pixel unit 520 and the second pixel unit 530, the spacing structure 503 is arranged between the pixel light isolation body 501 and the first pixel unit 520; and the spacing structure 503 is also arranged between the pixel light isolation body 501 and the second pixel unit 530.

In some embodiments, the arrangement position of the spacing structure 503 may be considered according to actual conditions such as process requirements, as long as the pixel light isolation body 501 may be effectively spaced from an adjacent pixel unit 411.

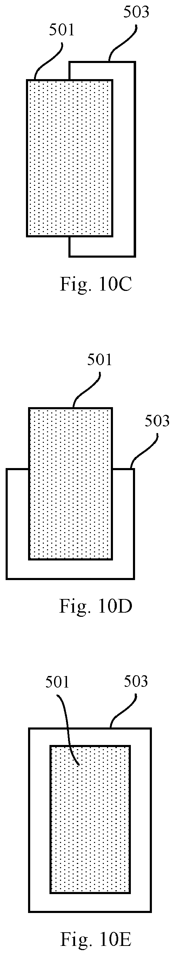

Referring to Figs. 10A, 10B, 10C, 10D and 10E, in some embodiments, the spacing structure 503 may cover a part or whole of the pixel light isolation body 501.

In some embodiments, as shown in Figs. 10A, 10B, 10C and 10D, the spacing structure 503 may cover a part of the pixel light isolation body 501, such as one side, two sides, three sides or more sides of the pixel light isolation body 501.

In some embodiments, as shown in Fig. 10E, the spacing structure 503 may cover the whole of the pixel light isolation body 501.

In some embodiments, the arrangement mode (e.g., covering a part or whole of the pixel light isolation body 501) of the spacing structure 503 may be considered according to actual conditions such as process requirements, as long as the pixel light isolation body 501 may be effectively spaced from an adjacent pixel unit 411.

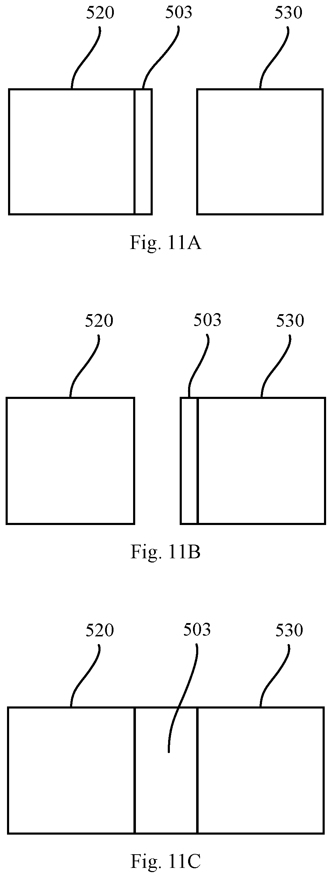

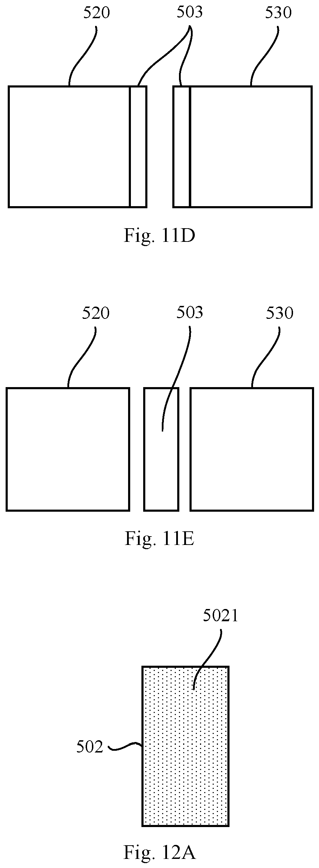

Referring to Figs. 11A, 11B, 11C, 11D and 11E, in some embodiments, the spacing structure 503 may be in contact with at least one of the two adjacent pixel units 411. Optionally, the spacing structure 503 may not be in contact with the two adjacent pixel units 411.

In some embodiments, as shown in Fig. 11A, when the two adjacent pixel units 411 include the first pixel unit 520 and the second pixel unit 530, the spacing structure 503 is in contact with the first pixel unit 520, but not in contact with the second pixel unit 530.

In some embodiments, as shown in Fig. 11B, when the two adjacent pixel units 411 include the first pixel unit 520 and the second pixel unit 530, the spacing structure 503 is in contact with the second pixel unit 530, but not in contact with the first pixel unit 520.

In some embodiments, as shown in Fig. 11C, when the two adjacent pixel units 411 include the first pixel unit 520 and the second pixel unit 530, the spacing structure 503 as a single integral structure is in contact with the first pixel unit 520 and the second pixel unit 530.

In some embodiments, as shown in Fig. 11D, when the two adjacent pixel units 411 include the first pixel unit 520 and the second pixel unit 530, one of two relatively independent spacing structures 503 is in contact with the first pixel unit 520, but not in contact with the second pixel unit 530, and the other spacing structure 503 is in contact with the second pixel unit 530, but not in contact with the first pixel unit 520.

In some embodiments, as shown in Fig. 11E, when the two adjacent pixel units 411 include the first pixel unit 520 and the second pixel unit 530, the spacing structure 503 is not in contact with the first pixel unit 520 or the second pixel unit 530.

In some embodiments, the arrangement mode (e.g., being in contact with at least one of the two adjacent pixel units 411) of the spacing structure 503 may be considered according to actual conditions such as process requirements, as long as the pixel unit light isolation body 501 may be effectively spaced from an adjacent pixel unit 411.

In some embodiments, at least one of the pixel light isolation body 501 and the spacing structure 503 may include the light isolation material 502.

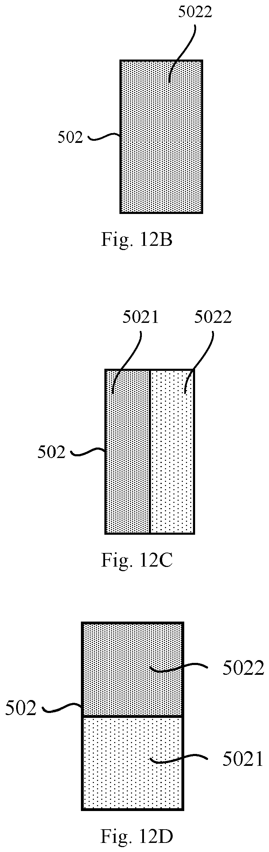

Referring to Figs. 12A, 12B, 12C and 12D, in some embodiments, the light isolation material 502 may include at least one of a light absorption material 5021 and a light reflection material 5022.

In some embodiments, as shown in Fig. 12A, the light isolation material 502 may include the light absorption material 5021.

In some embodiments, as shown in Fig. 12B, the light isolation material 502 may include the light reflection material 5022.

In some embodiments, as shown in Figs. 12C and 12D, the light isolation material 502 may include the light absorption material 5021 and the light reflection material 5022.

In some embodiments, the arrangement of the light isolation material 502 may be considered according to actual conditions such as process requirements, as long as the light isolation material 502 is capable of effectively achieving light isolation. Optionally, when the light isolation material 502 includes the light absorption material 5021 and the light reflection material 5022, the positions, proportions and the like of the light absorption material 5021 and the light reflection material 5022 may be considered according to actual conditions such as process requirements.

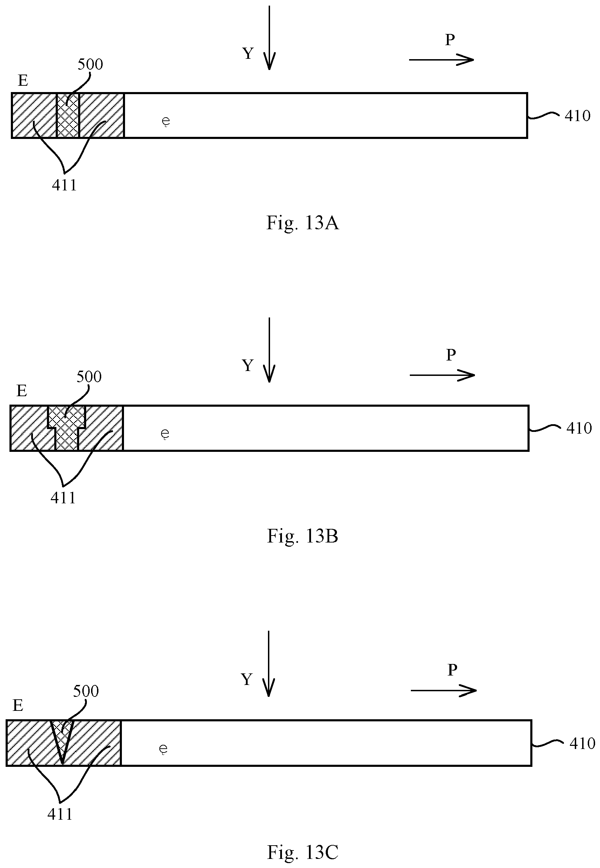

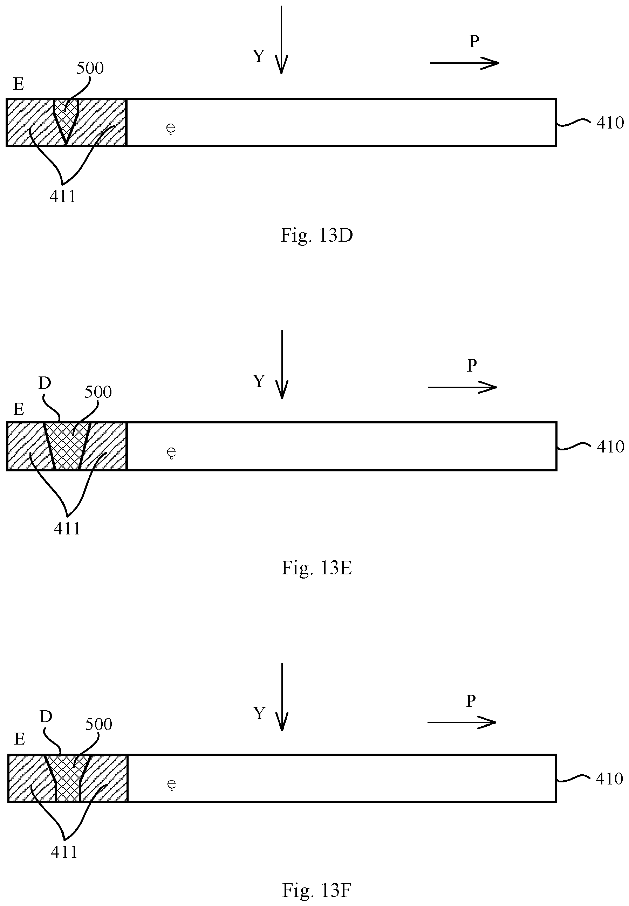

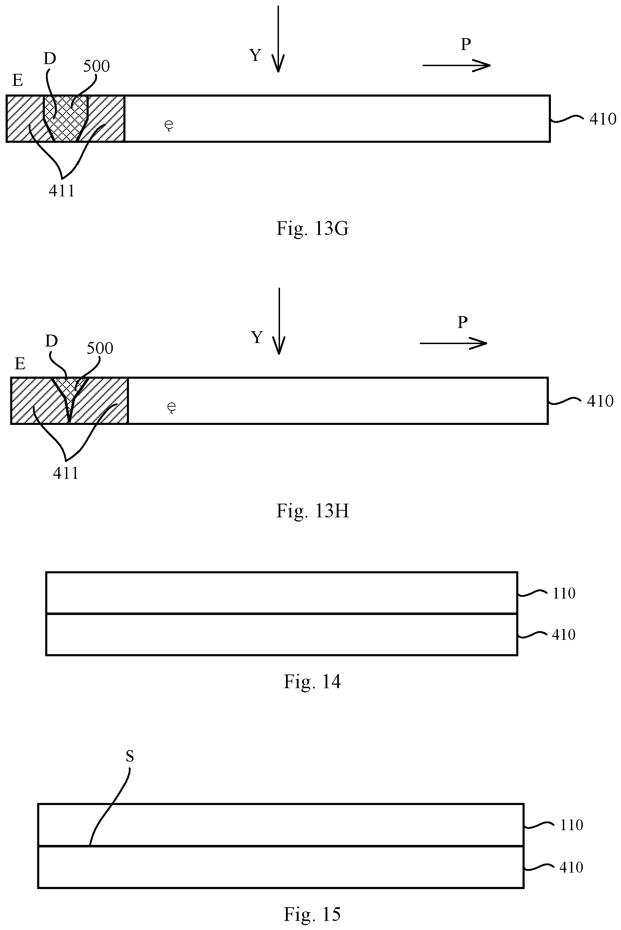

Referring to Figs. 13A, 13B, 13C, 13D, 13E, 13F, 13G and 13H, in some embodiments, part or all shapes in cross-sectional shapes of the pixel light isolation structures 500 along a light-incoming direction Y of the light conversion layer 410 include at least one of a rectangular quadrangle, a triangle and a trapezoid.

In some embodiments, as shown in Fig. 13A, a cross-sectional shape of the pixel light isolation structure 500 along the light-incoming direction Y of the light conversion layer 410 is a rectangular quadrangle.

In some embodiments, as shown in Fig. 13B, cross-sectional shapes of the pixel light isolation structure 500 along the light-incoming direction Y of the light conversion layer 410 include two rectangular quadrangles; and widths of the two rectangular quadrangles in a plane direction P of the light conversion layer 410 are different. Optionally, a rectangular quadrangle with a relatively large width in the plane direction P of the light conversion layer 410 may be close to a light-incoming side E of the light conversion layer 410; and a rectangular quadrangle with a relatively small width in the plane direction P of the light conversion layer 410 may be far away from the light-incoming side E of the light conversion layer 410. Optionally, a relative positional relationship between the two rectangular quadrangles may also be opposite to that shown in the figure; for example, the rectangular quadrangle with the relatively small width in the plane direction P of the light conversion layer 410 may be close to the light-incoming side E of the light conversion layer 410; and the rectangular quadrangle with the relatively large width in the plane direction P of the light conversion layer 410 may be far away from the light-incoming side E of the light conversion layer 410.

In some embodiments, as shown in Fig. 13C, a cross-sectional shape of the pixel light isolation structure 500 along the light-incoming direction Y of the light conversion layer 410 is a triangle. Optionally, one side of the triangle may be close to the light-incoming side E of the light conversion layer 410. Optionally, one side of the triangle may be far away from the light-incoming side E of the light conversion layer 410.

In some embodiments, as shown in Fig. 13D, cross-sectional shapes of the pixel light isolation structure 500 along the light-incoming direction Y of the light conversion layer 410 include a rectangular quadrangle and a triangle. Optionally, the rectangular quadrangle may be close to the light-incoming side E of the light conversion layer 410; and the triangle may be far away from the light-incoming side E of the light conversion layer 410. Optionally, the relative positional relationship between the rectangular quadrangle and the triangle may be opposite to that shown in the figure; for example, the triangle may be close to the light-incoming side E of the light conversion layer 410, and the rectangular quadrangle may be far away from the light-incoming side E of the light conversion layer 410. Optionally, one side of the triangle may face the light-incoming side E of the light conversion layer 410 or face away from the light-incoming side E of the light conversion layer 410.

In some embodiments, as shown in Fig. 13E, a cross-sectional shape of the pixel light isolation structure 500 along the light-incoming direction Y of the light conversion layer 410 is a trapezoid. Optionally, a lower base D of the trapezoid may face the light-incoming side E of the light conversion layer 410. Optionally, the lower base D of the trapezoid may face away from the light-incoming side E of the light conversion layer 410.

In some embodiments, as shown in Fig. 13F, cross-sectional shapes of the pixel light isolation structure 500 along the light-incoming direction Y of the light conversion layer 410 include a trapezoid and a rectangular quadrangle. Optionally, the rectangular quadrangle may be far away from the light-incoming side E of the light conversion layer 410; and the trapezoid may be close to the light-incoming side E of the light conversion layer 410. Optionally, the lower base D of the trapezoid may face the light-incoming side E of the light conversion layer 410 or face away from the light-incoming side E of the light conversion layer 410.

In some embodiments, as shown in Fig. 13G, cross-sectional shapes of the pixel light isolation structure 500 along the light-incoming direction Y of the light conversion layer 410 include a trapezoid and a rectangular quadrangle. Optionally, the rectangular quadrangle may be close to the light-incoming side E of the light conversion layer 410; and the trapezoid may be far away from the light-incoming side E of the light conversion layer 410. Optionally, the lower base D of the trapezoid may face the light-incoming side E of the light conversion layer 410 or face away from the light-incoming side E of the light conversion layer 410.

In some embodiments, as shown in Fig. 13H, cross-sectional shapes of the pixel light isolation structure 500 along the light-incoming direction Y of the light conversion layer 410 include a trapezoid and a triangle. Optionally, the trapezoid may be close to the light-incoming side E of the light conversion layer 410; and the triangle may be far away from the light-incoming side E of the light conversion layer 410. Optionally, the relative positional relationship between the trapezoid and the triangle may be opposite to that shown in the figure; for example, the triangle may be far away from the light-incoming side E of the light conversion layer 410, and the triangle may be close to the light-incoming side E of the light conversion layer 410. Optionally, the lower base D of the trapezoid may face the light-incoming side E of the light conversion layer 410 or face away from the light-incoming side E of the light conversion layer 410. Optionally, one side of the triangle may face the light-incoming side E of the light conversion layer 410 or face away from the light-incoming side E of the light conversion layer 410.

In some embodiments, the cross-sectional shape of the pixel light isolation structure 500 along the light-incoming direction Y of the light conversion layer 410 may be considered according to actual conditions such as process requirements, as long as the pixel light isolation structure 500 is capable of preventing the light emitted by the two adjacent pixel units 411 from being transmitted in an undesired direction (e.g., the light emitted by the two adjacent pixel units 411 is transmitted to each other).

In some embodiments, the pixel isolation structure 500 may include a structure and material capable of realizing light isolation, such as at least one of silver, aluminum and other metals. Optionally, the structure and material of the pixel light isolation structure 500 may be determined according to actual conditions such as process requirements, as long as the pixel light isolation structure 500 is capable of preventing the light emitted by the two adjacent pixel units 411 from being transmitted in an undesired direction (e.g., the light emitted by the two adjacent pixel units 411 is transmitted to each other).

In some embodiments, the pixel light isolation structure 500 may also include other structures and materials capable of realizing light absorption and light reflection, such as resin composition and titanium oxide (e.g., TiO₂). Optionally, the material for realizing light absorption may also include a black matrix (BM). Optionally, the structure and material of the pixel light isolation structure 500 may be determined according to actual conditions such as process requirements, as long as the pixel light isolation structure 500 is capable of preventing the light emitted by the two adjacent pixel units 411 from being transmitted in an undesired direction (e.g., the light emitted by the two adjacent pixel units 411 is transmitted to each other).

In some embodiments, the plurality of pixel units 411 may include at least one of pixels and subpixels.

In some embodiments, the plurality of pixel units 411 may include at least one pixel. Optionally, the plurality of pixel units 411 may include at least one subpixel. Optionally, the plurality of pixel units 411 may include at least one pixel and at least one subpixel.

In some embodiments, the pixel units 411 may be arranged according to actual conditions such as process requirements, so that the plurality of pixel units 411 include at least one of pixels and subpixels. Optionally, whether pixels and subpixels are included, the pixel units 411 may include other display (e.g., light conversion) structures besides the pixels and the subpixels.

In some embodiments, at least two pixel units 411 of the plurality of pixel units 411 may include the same or different light conversion materials. Optionally, main or all components of the light conversion material may include at least one of fluorescent powder, quantum dots and other materials.

Referring to Fig. 14, in some embodiments, the light-emitting module 100 may further include a light-emitting unit layer 110. Optionally, the light conversion layer 410 may be arranged at the light-emitting unit layer 110.

In some embodiments, part or all of the pixel light isolation structures 500 may be in direct contact with the light-emitting unit layer 110, or there may be a gap; for example, all of the pixel light isolation structures 500 are in direct contact with the light-emitting unit layer 110, or part of the pixel light isolation structures 500 are in direct contact with the light-emitting unit layer 110, and there is a gap between another part of the pixel light isolation structures 500 and the light-emitting unit layer 110, or there is a gap between all of the pixel light isolation structures 500 and the light-emitting unit layer 110. Optionally, the light isolation material may be partially or wholly arranged at a gap between the pixel light isolation structure 500 and the light-emitting unit layer 110.

In some embodiments, whether the pixel light isolation structure 500 is in direct contact with the light-emitting unit layer 100 may be considered according to actual conditions such as process requirements, as long as the pixel light isolation structure 500 is capable of preventing the light emitted by the two adjacent pixel units 411 from being transmitted in an undesired direction (e.g., the light emitted by the first pixel unit 520 and the second pixel unit 530 is transmitted to each other).

Referring to Fig. 15, in some embodiments, the light conversion layer 410 may be arranged at a light-exiting surface S of the light-emitting unit layer 110. Optionally, light from the light-emitting unit layer 110 may be incident into the light conversion layer 410 through the light-incoming side E of the light conversion layer 410.

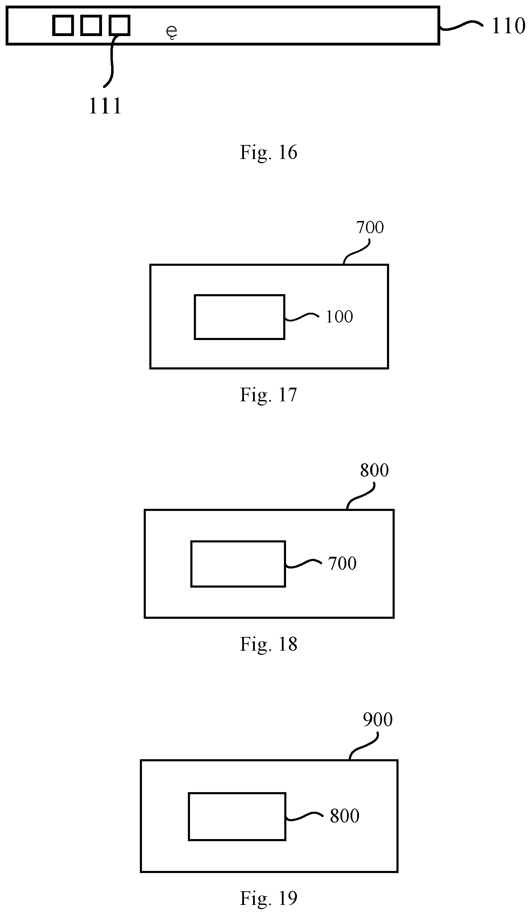

Referring to Fig. 16, in some embodiments, the light-emitting unit layer 110 may include a plurality of light-emitting units 111.

In some embodiments, part or all of the plurality of light-emitting units 111 may be unpackaged structures.

In some embodiments, part of the plurality of light-emitting units 111 may be unpackaged structures. Optionally, one, two, three or more of the plurality of light-emitting units 111 may only be light-emitting units, which have been arranged and are capable of emitting light, but have not been packaged and have no packaging layer and other packaging structures for packaging the light-emitting units; for example, at least one of the plurality of light-emitting units 111 may be a light-emitting unit, which is formed on the basis of epitaxial growth and other ways and comprises a first semiconductor layer, an active layer, a second semiconductor layer (or, may further comprise an electrode), but has not been packaged and has no packaging layer and other packaging structures for packaging the light-emitting unit comprising the first semiconductor layer, the active layer, the second semiconductor layer (or, further comprising an electrode).

In some embodiments, all of the plurality of light-emitting units 111 may be unpackaged structures. Optionally, all of the plurality of light-emitting units 111 may only be light-emitting units, which have been arranged and are capable of emitting light, but have not been packaged and have no packaging layer and other packaging structures for packaging the light-emitting units; for example, all of the plurality of light-emitting units 111 may be a light-emitting unit, which is formed on the basis of epitaxial growth and other ways and comprises a first semiconductor layer, an active layer, a second semiconductor layer (or, may further comprise an electrode), but has not been packaged and has no packaging layer and other packaging structures for packaging the light-emitting unit comprising the first semiconductor layer, the active layer, the second semiconductor layer (or, further comprising the electrode).

In some embodiments, part or all of the plurality of light-emitting units 111 may be packaged structures. Optionally, one, two, three or more of the plurality of light-emitting units 111 may not only be light-emitting units, which have been arranged and are capable of emitting light, and may also be packaged to form a packaging layer and other packaging structures for packaging the light-emitting units; for example, at least one of the plurality of light-emitting units 111 may be a light-emitting unit, which is formed on the basis of epitaxial growth and other ways and comprises a first semiconductor layer, an active layer, a second semiconductor layer (or, may further comprise an electrode), but has not been packaged and has no packaging layer and other packaging structures for packaging the light-emitting unit comprising the first semiconductor layer, the active layer, the second semiconductor layer (or, further comprising the electrode).

When part or all of the plurality of light-emitting units 111 are packaged structures, a packaged structure in which one or more light-emitting units 111 are packaged may be integrally regarded as one light-emitting unit 111; for example, if one packaged structure comprises one light-emitting unit 111, the packaged structure comprising the one light-emitting unit 111 may be regarded as one light-emitting unit 111; and for another example, if one packaged structure comprises three light-emitting units 111, the packaged structure comprising the three light-emitting units 111 may be regarded as one light-emitting unit 111.

In some embodiments, part or all of the plurality of light-emitting units 111 may be set to be unpackaged structures according to actual conditions such as process requirements, or part or all of the plurality of light-emitting units 111 may be set to be packaged structures according to actual conditions such as process requirements, as long as the pixel light isolation structure 500 is capable of preventing the light emitted by two adjacent pixel units 411 from being transmitted in an undesired direction (e.g., the light emitted by the first pixel unit 520 and the second pixel unit 530 is transmitted to each other).

In some embodiments, the plurality of light-emitting units 111 may comprise at least one of LED, Mini LED and Micro LED. Optionally, the plurality of light-emitting units 111 may comprise at least one LED. Optionally, the plurality of light-emitting units 111 may comprise at least one Mini LED. Optionally, the plurality of light-emitting units 111 may comprise at least one Mini LED. Optionally, the plurality of light-emitting units 111 may comprise at least one LED and at least one Mini LED. Optionally, the plurality of light-emitting units 111 may comprise at least one LED and at least one Micro LED. Optionally, the plurality of light-emitting units 111 may comprise at least one Mini LED and at least one Micro LED. Optionally, the plurality of light-emitting units 111 may comprise at least one LED, at least one Mini LED and at least one Micro LED. Optionally, the plurality of light-emitting units 111 may comprise other light-emitting devices besides LED, Mini LED and Micro LED.

In some embodiments, types of devices of the light-emitting unit 111, such as LED, Mini LED, Micro LED or other light-emitting devices, may be determined according to actual conditions such as process requirements.

Referring to Fig. 17, a display module 700 provided by embodiments of the present disclosure comprises the light-emitting module 100. In some embodiments, the display module 700 may support 3D display.

Referring to Fig. 18, a display screen 800 provided by embodiments of the present disclosure comprises the display module 700. In some embodiments, the display screen 800 may perform 3D display.

Referring to Fig. 19, a display 900 provided by embodiments of the present disclosure comprises the display screen 800. In some embodiments, the display 900 may perform 3D display. In some embodiments, the display 900 may further comprise other components for supporting normal operation of the display 900, such as at least one of a communication interface, a framework, a control circuit and the like.

According to the light-emitting module, the display module, the display screen and the display provided by embodiments of the present disclosure, light emitted by the light conversion layer is prevented from being transmitted in an undesired direction as far as possible by arranging the pixel light isolation structure between two adjacent pixel units in part or all of the plurality of pixel units in the light conversion layer, thereby benefiting improvement of a display effect and having a possibility of improving a light utilization rate.

The above description and drawings sufficiently illustrate the embodiments of the present disclosure to enable those skilled in the art to practice them. Other embodiments may comprise structural, logical, electrical, process, and other changes. The embodiments represent only possible changes. Unless expressly required, individual components and functions are optional and the order of operations may be changed. Parts and features of some embodiments may be included in or substituted for parts and features of other embodiments. The scope of the disclosed embodiments includes the full scope of the claims, and all available equivalents of the claims. When used in the present application, although the terms of "first", "second", etc. may be possibly used in the present application to describe various elements, these elements should not be limited by these terms. These terms are only used to distinguish one element from another. For example, without changing the meaning of the description, a first element may be called as a second element, and similarly, the second element may be called as the first element, as long as all of "the first elements" that appear are consistently renamed and all of "the second elements" that appear are consistently renamed. The first element and the second element are both elements, but may not be the same element. Moreover, the terms used in the present application are used to describe the embodiments only and not to limit the claims. As used in the illustration of the embodiments and the claims, unless clearly indicated in the context, the singular forms "a", "an" and "the" are also intended to include the plural forms. Similarly, the term "and/or" as used in the present application is meant to include any and all possible combinations of one or more of the associated listings. In addition, when used in the present application, the term "comprise" and its variations "comprises" and/or "comprising", etc., refer to the presence of stated features, integers, steps, operations, elements, and/or components, but does not preclude the presence or addition of one or more other features, integers, steps, operations, elements, components and/or groupings of these. Without further limitations, an element limited by the phrase "comprises a..." does not preclude the presence of additional identical elements in the process, method or device that includes the element. Herein, the difference of each embodiment from each other may be the focus of explanation. The same and similar parts among all of the embodiments may be referred to each other. For the method and product disclosed by the embodiments, if the method and product correspond to a method part disclosed by the embodiments, the description of the method part can be referred to for the related part.

Those skilled in the art may recognize that the units and algorithm steps of each example described in conjunction with the embodiments disclosed herein can be implemented in electronic hardware, or a combination of computer software and electronic hardware. Whether these functions are performed in hardware or software may depend on the specific application and design constraints of the technical solution. Those skilled in the art may use different methods for implementing the described functions for each particular application, but such implementations should not be considered beyond the scope of the embodiments of the present disclosure. Those skilled in the art may clearly understand that, for the convenience and brevity of description, the corresponding processes in the above method embodiments may be referred to for the working processes of the above systems, devices and units, which will not be repeated here.

In the embodiments disclosed herein, the disclosed method and product (including, but not limited to the apparatus and the device) may be realized in other ways. For example, the device embodiments described above are merely schematic. For example, the division of the units may be only a logical functional division, and may be an additional division manner in actual realization. For example, multiple units or components may be combined or integrated into another system, or some features may be ignored or not executed. In addition, the displayed or discussed mutual coupling or direct coupling or communication connection may be indirect coupling or communication connection through some interfaces, devices or units, and may be electrical, mechanical or other forms. The units described as separate components may or may not be physically separated, and the components shown as the units may or may not be physical units, that is, may be located in one place, or may be distributed on multiple network units. The present embodiments may be implemented by selecting some or all of the units according to actual needs. In addition, each functional unit in the embodiments of the present disclosure may be integrated into one processing unit, or each unit may exist physically alone, or two or more units may be integrated into one unit.

## Claims

1. A light-emitting module, comprising:
a light conversion layer, comprising a plurality of pixel units;
wherein a pixel light isolation structure is arranged between two adjacent pixel units in part or all of the plurality of pixel units.

2. The light-emitting module according to claim 1, wherein the pixel light isolation structure is arranged in a partial or whole region between the two adjacent pixel units.

3. The light-emitting module according to claim 2, wherein there is a pixel spacing region between the two adjacent pixel units; and the pixel light isolation structure is arranged in part or whole of the pixel spacing region.

4. The light-emitting module according to claim 3, wherein the two adjacent pixel units comprise a first pixel unit and a second pixel unit; the first pixel unit comprises a first surface close to the second pixel unit; and the second pixel unit comprises a second surface close to the first pixel unit;
wherein the pixel light isolation structure is arranged on at least one of the first surface and the second surface, or is not in contact with the first surface or the second surface.

5. The light-emitting module according to claim 4, wherein the pixel light isolation structure is arranged in a light-transmissive region of at least one of the first surface and the second surface.

6. The light-emitting module according to claim 1, wherein the pixel light isolation structure is a single integral closed structure.

7. The light-emitting module according to any one of claims 1-6, wherein the pixel light isolation structure comprises a pixel light isolation body.

8. The light-emitting module according to claim 7, wherein the pixel light isolation body comprises a light isolation material.

9. The light-emitting module according to claim 7, wherein the pixel light isolation structure further comprises a spacing structure arranged between the pixel light isolation body and a pixel unit in need of light isolation.

10. The light-emitting module according to claim 9, wherein the spacing structure is arranged between the pixel light isolation body and at least one of the two adjacent pixel units.

11. The light-emitting module according to claim 10, wherein the spacing structure covers a part or whole of the pixel light isolation body.

12. The light-emitting module according to claim 9, wherein at least one of the pixel light isolation body and the spacing structure comprises the light isolation material.

13. The light-emitting module according to claim 8 or 12, wherein the light isolation material comprises at least one of a light absorption material and a light reflection material.

14. The light-emitting module according to claim 1, wherein part or all shapes in cross-sectional shapes of the pixel light isolation structure along a light-incoming direction of the light conversion layer comprise at least one of a rectangular quadrangle, a triangle and a trapezoid.

15. The light-emitting module according to claim 14, wherein cross-sectional shapes of the pixel light isolation structure along a light-incoming direction of the light conversion layer comprise a trapezoid, and a lower base of the trapezoid faces a light-incoming side of the light conversion layer.

16. The light-emitting module according to claim 1, wherein the plurality of pixel units comprise:
at least one of pixels and subpixels.

17. The light-emitting module according to claim 16, wherein at least two pixel units of the plurality of pixel units comprise same or different light conversion materials.

18. The light-emitting module according to any one of claims 1-17, further comprising: a light-emitting unit layer;
wherein the light conversion layer is arranged at the light-emitting unit layer.

19. The light-emitting module according to claim 18, wherein the pixel light isolation structure is in direct contact with the light-emitting unit layer.

20. The light-emitting module according to claim 18, wherein the light conversion layer is arranged at a light-exiting surface of the light-emitting unit layer.

21. The light-emitting module according to claim 18, wherein the light-emitting unit layer comprises a plurality of light-emitting units.

22. The light-emitting module according to claim 21, wherein part or all of the plurality of light-emitting units are unpackaged structures.

23. The light-emitting module according to claim 21, wherein the plurality of light-emitting units comprise:
at least one of a Light-Emitting Diode (LED), a Mini LED and a Micro LED.

24. A display module, comprising the light-emitting module of any one of claims 1-23.

25. A display screen, comprising the display module of claim 24.

26. A display, comprising the display screen of claim 25.
